Europäisches Patentamt

(19) European Patent Office

Office européen des brevets

(11) Publication number : **0 589 641 A2**

# EUROPEAN PATENT APPLICATION

(12)

(21) Application number : 93307379.3

(22) Date of filing : 17.09.93

(51) Int. Cl.⁵ : **C23C 16/26,** C23C 16/30, C23C 16/32

(30) Priority : **24.09.92 US 949924**

(43) Date of publication of application :
**30.03.94 Bulletin 94/13**

(84) Designated Contracting States :
**BE DE ES FR GB SE**

(71) Applicant : **GENERAL ELECTRIC COMPANY**
**1 River Road**
**Schenectady, NY 12345 (US)**

(72) Inventor : **Park, Dong-Sil**
**2040 Garden Drive**
**Schenectady, New York 12309 (US)**
Inventor : **Diconza, Paul Joseph**
**Hollandale Apartments, 30A**
**Clifton Park, New York 12065 (US)**

(74) Representative : **Pratt, Richard Wilson et al**
**London Patent Operation G.E. Technical**
**Services Co. Inc. Essex House 12/13 Essex**
**Street**
**London WC2R 3AA (GB)**

(54) **Method of producing wear resistant articles.**

(57) Articles such as cutting tools are coated with an intermediate layer, on the surface of a shaped core, of at least one chromium-carbon compound having a ratio of chromium to carbon within a specific range, followed by deposition of a diamond layer on the intermediate layer. The intermediate layer significantly improves adhesion of the diamond layer to the surface of the core.

EP 0 589 641 A2

**Field of the Invention**

This invention is related to hard coated articles and, more particularly, is directed to wear resistant diamond coated articles such as cutting tools and turbine blades.

**Background of the Invention**

It is known that the performance of cutting tools, such as knife blades, drills, milling cutters, reamers, boring tools and saw blades can be significantly improved by coating the cutting surface with diamond. Diamond improves two properties: wear resistance, since it is the hardest substance known, and heat transfer, since it is the best conductor of heat. As a result, the cutting performance of diamond coated tools can be vastly superior to that of conventional high performance tools, such as non-coated cemented carbide tools.

Diamond coatings or films may be produced by chemical vapor deposition (CVD). In this process, diamonds are grown on a substrate in a substantially evacuated reaction chamber by activation, by a heated filament, a plasma or the like, of a mixture of a hydrocarbon, such as methane, and hydrogen.

The presence of a binder, such as cobalt, generally used in producing cemented carbide cutting tools, adversely affects the adhesion between a diamond layer produced by CVD or other methods and the surface of a cemented carbide tool on which it is deposited. It is believed that the binder acts as a catalyst which tends to produce adhesion-decreasing graphitic carbon during the initial stage of deposition of the diamond layer on the tool surfaces. Poor adhesion, as the result of formation of a weak graphite interfacial layer, is one of the most crucial hurdles faced in the deposition of functionally strong diamond layers or films on the cutting surfaces of cemented carbide cutting tools.

A further problem associated with diamond coated cutting tools is the thermal stress imparted at the diamond layer/tool interface during a typical machining operation. Due to its very low coefficient of thermal expansion, a film of diamond tends to delaminate and sometimes peels entirely from the surface of a cemented carbide tool, which has a much higher coefficient.

Various approaches have been tried to alleviate the aforementioned problems. For example, Saijo et al. in *ICMC,* San Diego, April 26, (1990), reported improved adhesion of diamond films deposited on the surfaces of hot-pressed binder-free tungsten carbide (WC) cutting tools that were decarburized prior to and then recarburized during the diamond deposition step. Without a binder such as cobalt, however, WC tools do not have adequate strength for practical applications.

A more common approach, reported by Shibuki et al. in *Surface and Coatings Technology, 36,* 295 (1988), is to dissolve the cobalt binder along the surface of a cemented carbide tool by an etching solution. This approach, however, has serious shortcomings including difficulty of nucleating diamond in etch pits, resulting in a weak interface. Additionally, the removal of binder (e.g., cobalt) by etching tends to weaken the surface layer and can lead to premature subsurface failure of the tool.

Schachner et al. in U. S. Patent 4,734,339 disclose an intermediate layer of $CrC_x$ where x varies from 0.45 to 2.1.

The present invention addresses the aforementioned problem of poor adhesion between a diamond layer and the underlying cutting tool surface.

The invention is also relevant to the manufacture of fan blades used in high performance turbine engines. It is known that such fan blades are subjected to extremely high sustained temperatures, as well as contact with dust particles present in the intake air, with abrasion and wear as a result. These fan blades are generally made of nickel or cobalt based superalloys. It would be advantageous to provide them with a coating of super hard, highly thermally conductive diamond. However, the presence of nickel or cobalt adversely affects the adhesion of the diamond layer to the superalloy surface. The present invention addresses the aforementioned problem of poor adhesion between the diamond layer and the underlying fan blade surface.

The invention is based on the discovery that deposition of a chromium carbide coating on a metal core prior to CVD deposition of diamond is particularly effective to improve the adhesion of the diamond to the core if the ratio of carbon to chromium is within a specific and relatively low range. The preferred values within this range are those which represent a bimodal distribution of discrete chromium carbide species.

**Statement of the Invention**

In one of its aspects, the invention is a method of producing a wear resistant cutting tool, comprising:

producing a shaped core of a material selected from the group consisting of tungsten carbide, titanium carbide, tantalum carbide and niobium carbide, the core being bonded by a binder material selected from the group consisting of cobalt, nickel and mixtures thereof;

depositing on the surface of said core an intermediate layer of at least one chromium-carbon compound corresponding to the formula $CrC_x$, where x varies from 0.26 to 0.43; and

depositing a diamond layer on top of the intermediate layer.

Another aspect of the invention is a method of producing a wear resistant fan blade of a turbine engine, comprising:

producing a shaped core of a material selected from the group consisting of nickel based superalloy and cobalt based superalloy;

carburizing the surface of the core;

depositing on the surface of the core an intermediate layer as described hereinabove;

activating the surface of the intermediate layer;

depositing a diamond layer on the surface of the intermediate layer; and

heat treating the core having the intermediate and diamond layers deposited thereon.

Other aspects of the invention include articles produced by the above-described methods.

## Detailed Description of the Preferred Embodiment

A wear resistant cutting tool prepared by the method of the present invention has a core of a material selected from the group consisting of tungsten carbide, titanium carbide, tantalum carbide and niobium carbide. Tungsten carbide is preferred. A binder is generally required to bond or cement tungsten carbide or the like, to produce the so called "cemented carbide" cutting tools. Suitable binder materials are nickel, cobalt and mixtures thereof; cobalt is preferred. The proportion of binder material in the core is generally about 4-20% by weight. The core has a desired shape, such as a multi-fluted twist drill. It may be produced by well known methods, such as hot pressing.

After the core is produced, an intermediate layer of a desired thickness is deposited on the surfaces of the core. The intermediate layer comprises at least one chromium-carbon compound of chromium and carbon corresponding to the formula $CrC_x$ where x varies from 0.26 to 0.43.

The ratio of carbon to chromium, represented herein by x, is based on the stoichiometry of discrete chromium carbides as shown by phase diagrams. Two of such carbides have the formulas $Cr_{23}C_6$ and $Cr_7C_3$, which are equivalent to $CrC_{0.261}$ and $CrC_{0.429}$, respectively. It is when the value of x is in the range including these discrete carbides that the kinetics of conversion to a more carbon-rich material, upon heat treatment during or after formation of the CVD diamond coating as described hereinafter, are believed to be such as to promote the formation of a rough, irregular interface between the chromium-carbon compound(s) and the diamond, promoting maximum adhesion. It is preferred for the stoichiometry of the chromium-carbon compound(s) to be bimodal; that is, for a mixture of the aforementioned $Cr_{23}C_6$ and $Cr_7C_3$ to be present.

The intermediate layer may be deposited on the core surfaces by any of the well known deposition methods. Illustrative methods are CVD, plasma enhanced chemical vapor deposition (PECVD), pack CVD, electroplating, physical vapor deposition (PVD) and the like.

In the preferred pack CVD method, the core is placed in an enclosure packed with a mixture of a metallic chromium powder, an activator and an inert filler. The particle size of the powder is not critical. Said mixture contains about 1-40%, preferably about 2-20% and most preferably about 10% by weight, of metallic chromium.

The activator may be an ammonium halide, preferably granulated ammonium iodide, or a gaseous hydrogen halide, preferably hydrogen chloride, conveyed into the enclosure by means of an inert gas such as argon. Granulated ammonium iodide is preferred. The proportion of the activator in the mixture is about 0.1-10%, preferably about 1-5% and most preferably about 2% by weight.

The balance of the mixture comprises the inert filler. Fillers suitable for use include alumina ($Al_2O_3$), silica ($SiO_2$), kaolin ($Al_2O_3 \cdot 2SiO_2 \cdot 2H_2O$) and mixtures thereof. Alumina powder is preferred. The particle size thereof is not critical.

The atmosphere inside the enclosure is controlled by the passage of an inert gas, such as argon or helium. Argon is preferred. If desired, the inert gas may be blended with up to about 10% by volume of hydrogen. The pressure of the inert gas flowing through the enclosure is not critical and one skilled in the pack CVD art will know that it may be maintained at, below or above atmospheric pressure. It is preferably at atmospheric pressure.

The enclosure is then heated to a temperature of about 600-1000°C, preferably about 800°C, by suitable means such as microwave or inductive heating. The process is continued for about 0.5-10 hours, preferably about 2 hours. The duration of the process is adjusted to provide an intermediate layer of the desired thickness. A thickness of about 0.1-10.0 microns, preferably about 6 microns, is suitable.

During the pack CVD process employing ammonium iodide as an activator, the following reactions take place:

$$NH_4I \rightarrow NH_3 + HI \quad (1)$$
$$2HI + Cr \rightarrow CrI_2 + H_2 \quad (2)$$

$CrI_2$ then reacts with WC of the core to form the aforementioned $CrC_x$.

If desired, the surface of the core may be carburized by a conventional process prior to the deposition of the intermediate layer. The process of carburization permits deposition of thicker intermediate layers, without raising the deposition temperature during the pack CVD process. This advantage is singularly important when the intermediate layer is deposited on structurally weak cutting tools, such as twist drills, which can be damaged or warped when subjected to high deposition temperatures. Thus, by carburizing the core surface prior to the deposition of the intermediate layer, one can have thicker intermediate layers that can effectively suppress cobalt migration from the core surface into the intermediate layer, thus, further improving the adhesion of the diamond to the intermediate layer.

During the carburizing process, the core is heated in an atmosphere comprising carbon monoxide or a hydrocarbon and hydrogen at a temperature in the range of about 800-1100°C, preferably about 1000-1050°C. The carburizing atmosphere preferably comprises a methane-hydrogen mixture comprising about 10% methane by volume. The duration of the process of carburization varies from about 30 minutes to about 3 hours and is preferably about 1 hour.

A diamond layer is then deposited on the intermediate layer by a conventional CVD process. The core is maintained for this purpose at a temperature of about 500-1100°C, preferably about 700-900°C. The CVD process may be conducted for about an hour to about 40 hours, preferably about 2-16 hours, depending on the thickness desired for the diamond layer. A layer having a thickness of about 1-20 microns, preferably about 2-8 microns, is generally suitable.

If desired, the surface of the intermediate layer may be activated before deposition of the diamond layer. The activation step comprises, for example, contacting the surface of the intermediate layer for about 2-60 and preferably about 5-30 minutes with an ultrasonically agitated suspension in an organic liquid of diamond particles having a size of about 0.5-4.0 microns. Methylene chloride is the preferred liquid, but an alcohol such as isopropyl alcohol may also be used. Alternatively, the surface of the intermediate layer may be rubbed with a suspension of diamond particles having a size of about 0.5-4.0 microns in hydrocarbon oil until the surface of the intermediate layer turns cloudy.

If desired, after depositing the diamond layer the core may be subjected to heat treatment to further enhance adhesion between the intermediate layer and the diamond layer. It is believed that heat treatment improves chemical bonding between the diamond layer and the intermediate layer. It is generally carried out at about 500-1000°C, preferably about 850°C, for about 30 minutes to about 4 hours, preferably for about 1 hour, in the presence of a gaseous mixture, preferably comprising about 1-10% by volume of hydrogen, a gaseous hydrocarbon or nitrogen, the balance being an inert gas such as argon.

The present invention, in addition to cutting tools, is also directed to other wear resistant bodies, such as fan blades of a turbine engine or knives.

A fan blade of a high performance turbine engine generally has a core of a material such as nickel based or cobalt based superalloy. Suitable superalloys are well known in the art. For example, a suitable nickel based superalloy comprises 53% nickel, 19% iron, 18% chromium, 5% niobium, 3% molybdenum, 1% titanium, 0.5% aluminum, 0.05% carbon and 0.005% boron by weight. An intermediate layer of a compound having the formula $CrC_x$, where x varies from 0.26 to 0.43, is disposed on the surface of the core and a diamond layer is disposed on the intermediate layer, as described hereinabove.

The invention is illustrated by the following examples.

**Example 1**

Cemented WC drills (0.1 centimeter in diameter) bonded with 6% by weight of cobalt binder were placed inside an enclosure packed with a mixture of 10% (by weight) -325 mesh chromium powder, 2% granulated ammonium iodide and the balance alumina powder. Argon gas at atmospheric pressure was conducted through the enclosure, which was maintained at various temperatures to produce intermediate layers of varying thicknesses as shown in Table 1 below.

## TABLE 1

| Temperature<br>in °C | Thickness of the<br>intermediate layer<br>in microns |
|:---:|:---:|
| 700 | 0.10 |
| 800 | 0.60 |
| 900 | 4.0 |

Scanning electron microscopy/energy dispersive X-ray spectroscopy (SEM/EDS) of the intermediate layer under the aforementioned conditions revealed uniform morphology, essentially free of cobalt and with a very minute quantity of tungsten. Electron spectroscopy for chemical analysis (ESCA) confirmed the aforementioned findings and according to X-ray diffraction analysis, the intermediate layer was composed of $Cr_{23}C_6$ and WC, with a trace of W.

The aforementioned drills after being coated with the aforementioned intermediate layer were then coated with a diamond layer in a hot filament CVD reactor chamber for two hours. The drills were heated to 800°C after being placed in the reactor chamber and a mixture of 1.7% by volume of methane, balance being hydrogen was conveyed into the reactor chamber. A uniformly covered coating of diamond having a thickness of 2 micrometers was obtained. For comparison, some bare cemented carbide drills, i.e., those having no intermediate layer deposited thereon, were also simultaneously coated with a diamond layer having a thickness of 2 micrometers.

The drills were then drill-tested at 60,000 revolutions per minute (RPM) and a feed rate of 150 inches per minute (IPM) against three layers of copper coated polymer laminates, i.e. printed circuit boards. After drilling 3000 hits or holes only very minimal damage to the diamond layer along the cutting edge was observed. By comparison, the drills having no intermediate layer, i.e. control samples, showed catastrophic peeling of the diamond layer after only 1000 hits.

Some of the coated drills were subjected to a series of 5 thermal quenching cycles including heating to 400°C and quenching in air at room temperature, in water at room temperature and in liquid nitrogen. Even after these extreme thermal cycling treatments, the coated drills exhibited no evidence of peeling.

**Example 2**

Slab shaped cemented WC cutting tool cores bonded with 6% by weight of cobalt were coated with an intermediate layer at 700°C and 900°C for two hours under the pack CVD conditions disclosed in Example 1. Table 2 lists the thicknesses of the intermediate layers obtained under various conditions.

### TABLE 2

| Temperature in °C | Thickness of the intermediate layer in microns |
|:---:|:---:|
| 700 | 0.1 |
| 900 | 4.0 |

After the deposition of the intermediate layer, the surfaces of the cores were then activated to improve nucleation of diamond by immersing them in an ultrasonically agitated suspension of diamond particles in isopropyl alcohol for 5 minutes. The size of the diamond particles in the aforementioned suspension varied from 0.5 to 1 micron. A diamond layer 2 microns in thickness was then deposited on top of the intermediate layer by the CVD process described in Example 1. A control sample of bare core, i.e., one with no intermediate layer thereon, was also simultaneously coated with a diamond layer.

The adhesion of the diamond layers to the cores was tested by using a Sebastian pull tester. The test revealed an adhesion strength in excess of 700 kg./cm.[2], which was the upper limit of the pull tester. By comparison, the adhesion strength of the diamond layer disposed on the aforementioned control sample was found to be 253 kg/cm$^2$ or less.

**Example 3**

A batch of cemented WC drills, similar to the ones in Example 1, were first carburized at 1050°C for one hour in an atmosphere of 10% by volume of methane, the balance being hydrogen. An intermediate layer having a thickness of 0.4 micron and a diamond layer having a thickness of 8 microns were then deposited on the surfaces of the drills by the deposition processes disclosed in Example 1.

The drill test, as described in Example 1, was used to test the coated drills. After 3000 hits, only minimal wear was observed on the diamond layer.

**Example 4**

A batch of cemented WC drills, similar to the ones in Example 1, were first carburized according to the procedure disclosed in Example 3. An intermediate layer having a thickness of 0.4 micron and a diamond layer having a thickness of 2 microns were then deposited on the surfaces of the drills by the deposition procedure disclosed in Example 1.

The drills were then heat treated at 850°C for about one hour in a reactor chamber through which a flowing stream of an argon-hydrogen mixture containing 1% by volume hydrogen was conveyed.

The heat treated drills were then subjected to the drill test described in Example 1. The diamond layer on the drill surface showed even less wear than that seen in Example 1, indicating further improvement in the adhesion strength of the diamond layers to the drill surfaces.

**Claims**

1. A method of producing a wear resistant cutting tool, comprising:

    producing a shaped core of a material selected from the group consisting of tungsten carbide, titanium carbide, tantalum carbide and niobium carbide, the core being bonded by a binder material selected from the group consisting of cobalt, nickel and mixtures thereof;

    depositing on the surface of said core an intermediate layer of at least one chromium-carbon compound corresponding to the formula $CrC_x$, where x varies from 0.26 to 0.43; and

    depositing a diamond layer on top of the intermediate layer.

2. The method of claim 1 wherein the intermediate layer is deposited by chemical vapor deposition by placing said core inside an enclosure packed with a mixture of metallic chromium, an activator and an inert filler, passing an inert gas through said enclosure and heating said core.

3. The method of claim 1 or claim 2 wherein the stoichiometry of the chromium-carbon intermediate layer is bimodal.

4. The method of any preceding claim wherein the reaction temperature is about 600-1000°C.

5. The method of any preceding claim further comprising carburizing the surface of said core prior to deposition of said intermediate layer.

6. The method of any preceding claim further comprising activating the surface of said intermediate layer prior to deposition of said diamond layer.

7. The method of any preceding claim further comprising heat treating said core after deposition of said diamond layer.

8. A method of producing a wear resistant fan blade of a turbine engine comprising:

    producing a shaped core of a material selected from the group consisting of nickel based superalloy and cobalt based superalloy;

    carburizing the surface of the core;

    depositing on the surface of said core an intermediate layer of at least one chromium-carbon compound corresponding to the formula $CrC_x$, where x varies from 0.26 to 0.43; and

activating the surface of the intermediate layer;

depositing a diamond layer on the surface of the intermediate layer; and

heat treating the core having the intermediate and diamond layers deposited thereon.

9. A wear resistant cutting tool comprising:

a shaped of a material selected from the group consisting of tungsten carbide, titanium carbide, tantalum carbide and niobium carbide, said core being bonded by a binder material selected from the group consisting of cobalt, nickel and mixtures thereof;

10. A wear resistant fan blade of a turbine engine comprising:

a shaped core of a material selected from the group consisting of nickel based superalloy and cobalt based superalloy;

an intermediate layer of at least one chromium-carbon compound corresponding to the formula $CrC_x$, where x varies from 0.26 to 0.43, disposed on the surface of said core; and

a diamond layer on said intermediate layer.